# FASCICULE DE BREVET EUROPEEN

(11) **EP 0 836 271 B1**
(45) Date de publication et mention de la délivrance du brevet: **29.01.2003**
(21) Numéro de dépôt: 97203036.5
(22) Date de dépôt: 02.10.1997
(51) Int. Cl.: H03B 5/12

(54) **Oscillateur intégré et radio-téléphone mettant en oeuvre un tel oscillateur.**
Integrierter Oszillator und einen solchen Oszillator verwendendes Funktelefon
Integrated circuit oscillator and radiotelephone using such an oscillator

(30) Priorité: 10.10.1996 FR 9612380
(43) Date de publication de la demande: 15.04.1998
(73) Titulaire: Koninklijke Philips Electronics N.V., 5621 BA Eindhoven (NL)
(72) Inventeur: Philippe, Pascal, 75008 Paris (FR); Murgulescu, Mihai, 75008 Paris (FR); Jovenin, Fabrice, 75008 Paris (FR)
(74) Mandataire: Chaffraix, Jean

(56) Documents cités:
- EP-A- 0 351 153
- EP-A- 0 660 504
- US-A- 4 593 256
- US-A- 5 138 285
- US-A- 5 140 286
- US-A- 5 418 500

## Description

La présente invention concerne un oscillateur destiné à fournir un signal de sortie dont la fréquence est variable en fonction d'une tension dite de réglage, comportant :
- une partie passive présentant deux bornes de sortie entre lesquelles est prélevé le signal de sortie et une borne d'entrée destinée à recevoir la tension de réglage, et comprenant deux capacités variables disposées en série, formant ainsi une branche capacitive dont les extrémités sont couplées aux bornes de sortie, et dont un noeud intermédiaire entre les capacités variables constitue la borne d'entrée, les bornes de sortie étant reliées à une première borne d'alimentation via deux inductances de valeurs nominales égales,
- une partie active comprenant un premier et un deuxième transistors présentant chacun une borne dite de polarisation, une borne dite de référence et une borne dite de sortie, les bornes de sortie des premier et deuxième transistors étant reliées aux bornes de sortie de la partie passive, les bornes de référence desdits transistors étant reliées via une source de courant à une deuxième borne d'alimentation, les bornes de polarisation des premier et deuxième transistors étant respectivement reliées aux bornes de sortie des deuxième et premier transistor via deux capacités dites de couplage de valeurs nominales égales.

Un tel oscillateur est connu de l'article "A Monolithic GaAs IC for Heterodyne Generation of RF Signals", de Mr. Rory L. VAN TUYL, publié dans IEEE Transactions on Electron Devices, Vol. ED-28, No. 2. Les transistors présents dans cet oscillateur sont réalisés en arseniure de gallium, ce qui leur confère l'avantage de la rapidité. Ces transistors génèrent toutefois un bruit basse-fréquence important, ce qui est un inconvénient majeur dans des applications de radio-téléphonie, où la fréquence du signal de sortie de l'oscillateur est utilisée pour sélectionner un signal radio-électrique au sein d'une gamme de fréquences donnée. Le signal généré par l'oscillateur doit alors posséder une grande pureté spectrale, qui ne peut pas être obtenue au moyen de transistors en arseniure de gallium.

Il est également connu du document EP 0 660 504 un oscillateur destiné à fournir un signal de sortie dont la fréquence est variable en fonction d'une tension de réglage dont l'objet est l'atténuation du bruit basse-fréquence généré par les transistors formant l'étage oscillateur.

Une plus grande pureté spectrale peut être obtenue en utilisant des transistors bipolaires connectés en paire différentielle conformément au paragraphe introductif. Un tel oscillateur, lorsqu'il est utilisé dans un téléphone portable, de type GSM par exemple, reçoit une tension d'alimentation régulée élaborée sur la base d'une tension présente aux bornes d'une batterie incluse dans ledit téléphone. Cette tension régulée présente, par nature, des variations basse-fréquence qui sont susceptibles de parvenir à la partie passive de l'oscillateur et d'altérer la pureté spectrale du signal généré par celui-ci.

L'invention a pour but de remédier à cet inconvénient, en présentant un oscillateur dont la partie active est réalisée au moyen de transistors bipolaires, et dans lequel la sensibilité de la partie passive aux variations de la tension d'alimentation est fortement atténuée.

En effet, selon l'invention, un oscillateur du type décrit dans le paragraphe introductif est caractérisé en ce que, les premier et deuxième transistors étant des transistors bipolaires dont les bases, collecteurs et émetteurs constituent respectivement les bornes de polarisation, de sortie et de référence, la partie passive comporte deux filtres passe-haut, chacun étant inséré entre l'une des bornes de sortie et l'une des capacités variables de manière à isoler l'oscillateur des variations basse-fréquence de la tension d'alimentation.

L'emploi de filtres passe-haut a pour effet d'isoler la partie active de l'oscillateur des variations basse-fréquence de la tension d'alimentation.

Dans un mode de réalisation avantageux de l'invention, un oscillateur tel que décrit ci-dessus est caractérisé en ce que chaque filtre passe-haut est constitué d'une capacité dite de filtrage, disposée entre l'une des bornes de sortie et l'une des capacités variables, et d'une résistance, disposée entre la deuxième borne d'alimentation et le noeud situé entre ladite capacité variable et la capacité de filtrage.

Cette structure simple des filtres passe-haut permet une bonne protection de la partie active contre les signaux basse-fréquence, tout en ne nécessitant qu'une surface réduite pour sa réalisation.

La source de courant de la paire différentielle peut également constituer une source de bruit basse-fréquence. Un mode de réalisation particulier de l'invention présente donc un oscillateur tel que décrit plus haut, caractérisé en ce que la source de courant reliant les bornes de référence des premier et deuxième transistors à la deuxième borne d'alimentation est une résistance.

Outre l'avantage de la simplicité de réalisation, qui se traduit par une économie de surface, cette source de courant à base de résistance présente également l'avantage de générer moins de bruit basse-fréquence que le circuit de polarisation d'une source de courant à transistor.

Dans la plupart des applications portables, il est souhaitable de réduire l'encombrement des circuits électroniques, afin de diminuer le poids et le volume des appareils qui les contiennent. Un mode de réalisation avantageux de l'invention permet de réduire l'oscillateur à un seul circuit intégré, entouré d'un boîtier de connexion. Un tel oscillateur est caractérisé en ce que, les parties active et passive étant réalisées au sein d'un même circuit intégré inclus dans un boîtier qui présente une première et une deuxième broches constituant les première et deuxième bornes d'alimentation et des broches reliées aux bornes d'entrée et de sortie du circuit intégré, les inductances sont constituées par des fils conducteurs reliant les bornes de sortie de la partie passive à la première broche du boîtier.

L'inductance intrinsèque des fils effectuant les connexions électriques entre les broches du boîtier et les bornes du circuit intégré est ici mise à profit. Ceci permet d'éviter l'adjonction d'inductances externes au boîtier contenant l'oscillateur, et se traduit par une insertion plus simple de l'oscillateur au sein de l'appareil qui l'utilise. La conception et la fabrication dudit appareil s'en trouvent donc simplifiées, ce qui diminue son coût total.

Ainsi que démontré ci-dessus, un tel oscillateur est particulièrement bien adapté à des utilisations au sein d'appareils portables. L'invention concerne donc également un appareil de radio-téléphonie agencé pour émettre ou recevoir des signaux radio-électriques dans une gamme de fréquences donnée, appareil comprenant un système d'antenne et de filtrage permettant la réception d'un signal dont la fréquence est sélectionnée au sein de ladite gamme de fréquences, appareil dans lequel une conversion de fréquence, à partir de la fréquence à sélectionner vers une fréquence intermédiaire, est réalisée au moyen d'un mélangeur recevant le signal radio-électrique sélectionné, d'une part, et un signal émis en sortie d'un oscillateur local tel que décrit plus haut, d'autre part, signal dont la fréquence est mesurée par un module de contrôle, lequel délivre en sortie une tension dite de réglage permettant de régler la fréquence du signal de sortie de l'oscillateur local de sorte que celle-ci soit égale à la différence entre la fréquence à sélectionner et la fréquence intermédiaire.

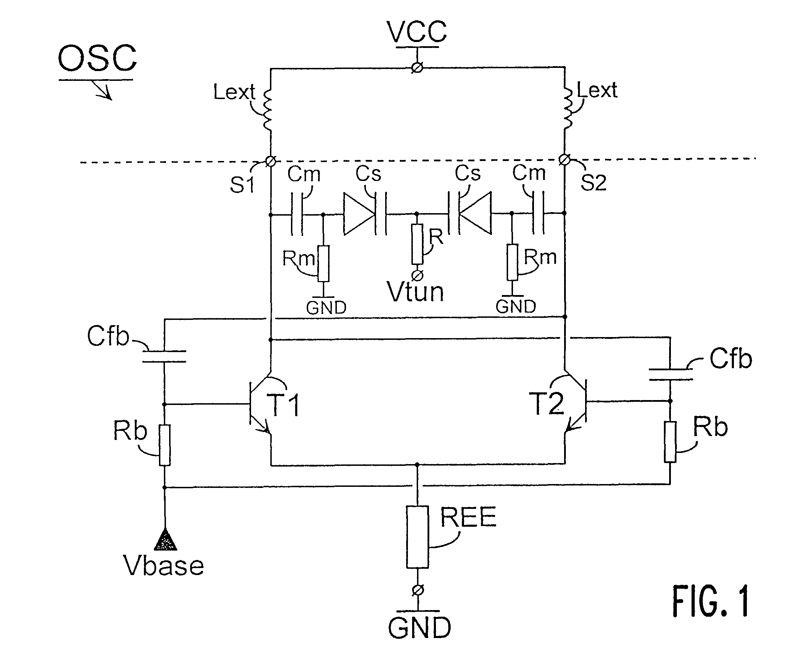

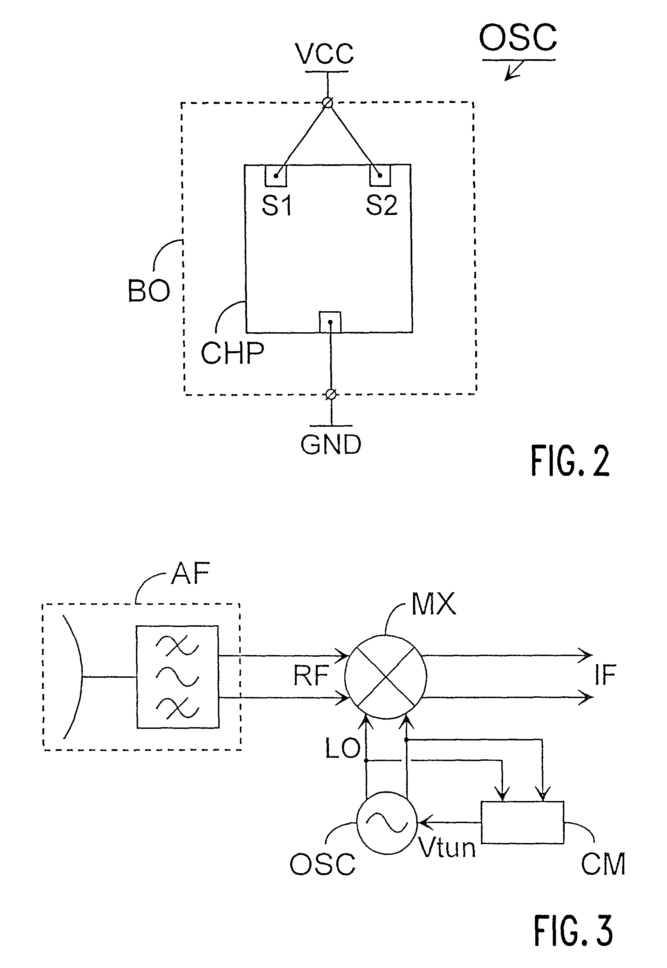

L'invention sera mieux comprise à l'aide de la description suivante de quelques modes de réalisation, faite à titre d'exemple non-limitatif et en regard des dessins annexés, dans lesquels :
. la figure 1 est un schéma électrique partiel d'un oscillateur suivant l'invention,
. la figure 2 est une représentation très schématique d'un mode de réalisation avantageux de l'invention, et
. la figure 3 est un schéma fonctionnel partiel d'un appareil de radio-téléphonie mettant en oeuvre un oscillateur conforme à l'invention.

La figure 1 représente schématiquement un oscillateur OSC destiné à fournir un signal de sortie LO dont la fréquence est variable en fonction d'une tension dite de réglage Vtun. L'oscillateur OSC comporte une partie passive qui présente deux bornes de sortie S1 et S2 entre lesquelles est prélevé le signal de sortie LO, et une borne d'entrée destinée à recevoir la tension de réglage Vtun. La partie passive comprend deux capacités variables Cs disposées en série, formant ainsi une branche capacitive dont les extrémités constituent les bornes de sortie S1 et S2. Ces capacités sont ici réalisées sous la forme de diodes Schottky polarisées en inverse. Le noeud intermédiaire entre les capacités variables Cs est relié via une résistance R à la borne d'entrée, et les bornes de sortie S1 et S2 sont reliées à une première borne d'alimentation VCC via deux inductances Lext de valeurs nominales égales. L'oscillateur OSC comporte en outre une partie active comprenant un premier et un deuxième transistors bipolaires T1 et T2 présentant chacun une base, un émetteur et un collecteur. Les collecteurs des premier et deuxième transistors T1 et T2 sont reliés aux bornes de sortie S1 et S2 de la partie passive. Les émetteurs desdits transistors T1 et T2 sont reliés via une source de courant, constituée ici d'une résistance REE, à une deuxième borne d'alimentation GND. Les bases des premier et deuxième transistors T1 et T2 sont respectivement reliées aux collecteurs des deuxième et premier transistor T2 et T1 via deux capacités de couplage Cfb de valeurs nominales égales. Les bases des transistors T1 et T2 reçoivent une tension de polarisation Vbase via une résistance de base Rb. Cette tension Vbase peut être dérivée de la tension de la première borne d'alimentation VCC, au moyen d'un pont diviseur, par exemple. La partie passive comporte deux filtres passe-haut, chacun étant inséré entre l'une des bornes de sortie S1 ou S2 et l'une des capacités variables Cs. Chaque filtre passe-haut est constitué d'une capacité de filtrage Cm, disposée entre l'une des bornes de sortie S1 ou S2 et l'une des capacités variables Cs, et d'une résistance Rm, disposée entre la deuxième borne d'alimentation GND et le noeud situé entre ladite capacité variable Cs et la capacité de filtrage Cm.

Une telle structure rend possible une intégration complète de l'oscillateur au sein d'un boîtier de circuit intégré. En effet, l'ensemble de la structure décrite ci-dessus est intégrable au sein d'un même circuit intégré, hormis les inductances Lext reliant les bornes de sortie S1 et S2 de la partie passive à la première borne d'alimentation VCC, qui doivent être réalisées de manière externe au circuit.

La figure 2 représente très schématiquement un mode de réalisation avantageux de l'invention, dans lequel les parties active et passive de l'oscillateur OSC sont réalisées au sein d'un même circuit intégré CHP, inclus dans un boîtier BO qui présente une première et une deuxième broches constituant les première et deuxième bornes d'alimentation VCC et GND. Les inductances Lext sont constituées par des fils conducteurs reliant les bornes de sortie S1 et S2 de la partie passive à la première broche VCC du boîtier BO. Dans le but d'obtenir une opposition de phase la plus parfaite possible entre les signaux présents sur les bornes S1 et S2, les différents éléments constituant les parties active et passive de l'oscillateur sont avantageusement disposés de manière à respecter au maximum la symétrie que présente le schéma électrique donné en Figure 1.

L'intégration complète au sein d'un boîtier unique de l'oscillateur OSC permet d'éviter l'adjonction d'inductances externes au boîtier, ce qui simplifie la structure de l'appareil qui le met en oeuvre, et diminue son encombrement ainsi que son coût.

Un tel oscillateur est donc particulièrement bien adapté à des utilisations au sein d'appareils portables. La figure 3 montre un exemple d'application de l'invention. Elle représente partiellement un appareil de radio-téléphonie, tel un téléphone cellulaire de type GSM, agencé pour émettre ou recevoir des signaux radio-électriques dans une gamme de fréquences donnée. Cet appareil comprend un système d'antenne et de filtrage AF permettant la réception d'un signal dont la fréquence RF est sélectionnée au sein de ladite gamme de fréquences. Une conversion de fréquence, à partir de la fréquence RF à sélectionner vers une fréquence intermédiaire IF, est réalisée dans cet appareil au moyen d'un mélangeur MX recevant le signal radio-électrique sélectionné, d'une part, et un signal LO émis en sortie d'un oscillateur local OSC tel que décrit plus haut, d'autre part. La fréquence du signal LO est mesurée par un module de contrôle CM, lequel délivre en sortie une tension dite de réglage Vtun permettant de régler la fréquence du signal de sortie LO de l'oscillateur local OSC de sorte que celle-ci soit égale à la différence entre la fréquence RF à sélectionner et la fréquence intermédiaire IF.

L'intégration complète de l'oscillateur OSC selon l'invention et la grande pureté spectrale du signal de sortie qu'il délivre lui permettent de respecter la norme GSM qui détermine un niveau de bruit maximal en sortie de l'oscillateur, tout en présentant un encombrement très réduit.

## Revendications

1. Oscillateur destiné à fournir un signal de sortie dont la fréquence est variable en fonction d'une tension dite de réglage, comportant :
- une partie passive présentant deux bornes de sortie (S1, S2) entre lesquelles est prélevé le signal de sortie et une borne d'entrée (Vtun) destinée à recevoir la tension de réglage, et comprenant deux capacités variables (Cs, Cs) disposées en série, formant ainsi une branche capacitive dont les extrémités sont couplées aux bornes de sortie (S1, S2), et dont un noeud intermédiaire entre les capacités variables constitue la borne d'entrée, les bornes de sortie étant reliées à une première borne d'alimentation (VCC) via deux inductances (Lext, Lext) de valeurs nominales égales,
- une partie active comprenant un premier transistor(T1) et un deuxième transistors (T2) présentant chacun une borne dite de polarisation, une borne dite de référence et une borne dite de sortie, les bornes de sortie des premier et deuxième transistors étant reliées aux bornes de sortie (S1, S2) de la partie passive, les bornes de référence desdits transistors étant reliées via une source de courant à une deuxième borne d'alimentation (GND), les bornes de polarisation des premier et deuxième transistors étant respectivement reliées aux bornes de sortie des deuxième et premier transistors via deux capacités (Cfb, Cfb) dites de couplage de valeurs nominales égales,
oscillateur **caractérisé en ce que**, les premier et deuxième transistors (T1, T2) étant des transistors bipolaires dont les bases, collecteurs et émetteurs constituent respectivement les bornes de polarisation, de sortie et de référence, la partie passive comporte deux filtres passe-haut, chacun étant inséré entre l'une des bornes de sortie et l'une des capacités variables de manière à isoler l'oscillateur des variations basse-fréquence de la tension d'alimentation.

2. Oscillateur selon la revendication 1, **caractérisé en ce que** chaque filtre passe-haut est constitué d'une capacité (Cm) dite de filtrage, disposée entre l'une des bornes de sortie et l'une des capacités variables, et d'une résistance (Rm), disposée entre la deuxième borne d'alimentation (GND) et le noeud situé entre ladite capacité variable et la capacité de filtrage (Cm).

3. Oscillateur selon l'une des revendications 1 ou 2, **caractérisé en ce que** la source de courant reliant les bornes de référence des premier et deuxième transistors (T1, T2) à la deuxième borne d'alimentation est une résistance (REE).

4. Oscillateur selon l'une quelconque des revendications 1 à 3, **caractérisé en ce que**, les parties active et passive étant réalisées au sein d'un même circuit intégré (CHP), inclus dans un boîtier (BO) qui présente une première et une deuxième broches constituant les première et deuxième bornes d'alimentation (VCC, GND) et des broches reliées aux bornes d'entrée et de sortie du circuit intégré, les inductances (Lext, Lext) sont constituées par des fils conducteurs reliant les bornes de sortie (S1, S2) de la partie passive à la première broche du boîtier.

5. Appareil de radio-téléphonie agencé pour émettre ou recevoir des signaux radio-électriques dans une gamme de fréquences donnée, appareil comprenant un système d'antenne et de filtrage (AF) permettant la réception d'un signal dont la fréquence (RF) est sélectionnée au sein de ladite gamme de fréquences, appareil dans lequel une conversion de fréquence, à partir de la fréquence à sélectionner vers une fréquence intermédiaire (IF), est réalisée au moyen d'un mélangeur (MX) recevant le signal radio-électrique sélectionné, d'une part, et un signal (LO) émis en sortie d'un oscillateur local (OSC), d'autre part, signal dont la fréquence est mesurée par un module de contrôle (CM), lequel délivre en sortie une tension (Vtun) dite de réglage permettant de régler la fréquence du signal de sortie (LO) de l'oscillateur local de sorte que celle-ci soit égale à la différence entre la fréquence à sélectionner (RF) et la fréquence intermédiaire (IF), appareil de radio-téléphonie **caractérisé en ce que** l'oscillateur local (OSC) est conforme à l'une quelconque des revendications 1 à 4.

## Claims

1. An oscillator intended to provide an output signal having a frequency which is variable as a function of a tuning voltage, comprising:
- a passive part having two output terminals (S1, S2) between which the output signal is taken, and an input terminal (Vtun) intended to receive the tuning voltage, and comprising two series-arranged variable capacitances (Cs, Cs), thus forming a capacitive branch whose extremities are coupled to the output terminals, and of which a junction point between the variable capacitances constitutes the input terminal, the output terminals being connected to a first power supply terminal (VCC) via two inductances (Lext, Lext) having equal nominal values,
- an active part comprising a first (T1) and a second (T2) transistor each having a biasing terminal, a reference terminal and an output terminal, the output terminals of the first and second transistors being connected to the output terminals (S1, S2) of the passive part, the reference terminals of said transistors being connected to a second power supply terminal (GND) via a current source, the biasing terminals of the first and second transistors being connected to the output terminals of the second and first transistors, respectively, via two coupling capacitances (Cfb, Cfb) having equal nominal values,
**characterized in that**, the first and second transistors (T1, T2) being bipolar transistors whose bases, collectors and emitters constitute the biasing terminals, the output terminals and the reference terminals, respectively, the passive part comprises two high-pass filters, each being inserted between one of the output terminals and one of the variable capacitances so as to isolate the oscillator from low-frequency variations of the power supply voltage.

2. An oscillator as claimed in claim 1, **characterized in that** each high-pass filter is constituted by a filtering capacitor (Cm) arranged between one of the output terminals and one of the variable capacitances, and a resistor (Rm) arranged between the second power supply terminal (GND) and a node situated between said variable capacitance and the filtering capacitor (Cm).

3. An oscillator as claimed in claim 1 or 2, **characterized in that** the current source connecting the reference terminals of the first and second transistors (T1, T2) to the second power supply terminal is a resistor (REE).

4. An oscillator as claimed in any one of claims 1 to 3, **characterized in that**, the active and passive parts being realized within the same integrated circuit (CHP) incorporated in a housing (BO) having a first and a second pin constituting the first and second power supply terminals (VCC, GND) and pins connected to the input and output terminals of the integrated circuit, the inductances (Lext, Lext) are constituted by conducting wires connecting the output terminals (S1, S2) of the passive part to the first pin of the housing.

5. A radio-telephone apparatus used for transmitting or receiving radio-electric signals in a given range of frequencies, which apparatus comprises an antenna and filtering system (AF) allowing reception of a signal having a frequency (RF) which is selected within said range of frequencies, in which apparatus a frequency conversion, from the frequency to be selected to an intermediate frequency (IF), is realized by means of a mixer (MX) receiving the selected radio-electric signal and a signal (LO) transmitted at the output of a local oscillator (OSC), said signal having a frequency which is measured by a control module (CM) which supplies a tuning voltage (Vtun) at the output allowing control of the frequency of the output signal (LO) of the local oscillator such that said frequency is equal to the difference between the frequency (RF) to be selected and the intermediate frequency (IF), said radio-telephone apparatus being **characterized in that** the local oscillator (OSC) is an oscillator as claimed in any one of claims 1 to 4.

## Patentansprüche

1. Oszillator zum Abgeben eines Ausgangssignals mit einer je nach der sogenannten Regelspannung variablen Frequenz, bestehend aus:
- einem passiven Teil mit zwei Ausgangsklemmen (S1, S2), an denen das Ausgangssignal entnommen wird, und einer Eingangsklemme (Vtun) für den Erhalt einer Regelspannung, und mit zwei in Serie geschalteten variablen Kapazitäten (Cs, Cs), die so einen kapazitiven Zweig bilden, dessen Enden an die Ansgangsklemmen (S1, S2) gekoppelt sind, und wobei ein Knoten zwischen den variablen Kapazitäten die Eingangsklemme bildet und die Ausgangsklemmen über zwei Induktanzen (Lext, Lext) gleichen nominalen Werts mit einer ersten Versorgungsklemme (VCC) verbunden sind,
- einem aktiven Teil mit einem ersten Transistor (T1) und einem zweiten Transistor (T2) mit jeweils einer sogenannten Polarisierungsklemme, einer sogenannten Bezugsklemme und einer sogenannten Ausgangsklemme, wobei die Ausgangsklemmen des ersten und zweiten Transistors mit den Ausgangsklemmen (S1, S2) des passiven Teils verbunden sind, die Bezugsklemmen der besagten Transistoren über eine Stromquelle mit einer zweiten Versorgungsklemme (GND) verbunden sind, und die Polarisierungsklemmen des ersten und zweiten Transistors respektive mit den Ausgangsklemmen des zweiten und ersten Transistors über zwei sogenannte Kopplungskapazitäten (Cfb, Cfb) gleichen nominalen Werts verbunden sind,
Oszillator **dadurch gekennzeichneter, dass** der erste und zweite Transistor (T1, T2) bipolare Transistoren sind, deren Basen, Kollektoren und Emitter respektive die Polarisierungs-, Ausgangs- und Bezugsklemmen bilden, und der passive Teil zwei Hochpassfilter aufweist, die jeweils zwischen eine der Ausgangsklemmen und eine der variablen Kapazitäten eingefügt sind, um den Oszillator gegen Niederfrequenzvariationen der Versorgungsspannung zu isolieren.

2. Oszillator nach Anspruch 1, **dadurch gekennzeichneter, dass** jeder Hochpassfilter aus einer sogenannten Filterungskapazität (Cm), die zwischen einer der Ausgangsklemmen und einer der variablen Kapazitäten angeordnet ist, und aus einem Widerstand (Rm) gebildet wird, der zwischen der zweiten Versorgungsklemme (GND) und dem zwischen der besagten variablen Kapazität und der Filterungskapazität (Cm) liegenden Knoten angeordnet ist.

3. Oszillator nach einem der Ansprüche 1 oder 2, **dadurch gekennzeichnet, dass** die die Bezugsklemmen des ersten und zweiten Transistors (T1, T2) mit der zweiten Versorgungsklemme verbindende Stromquelle ein Widerstand (REE) ist.

4. Oszillator nach einem geliebigen der Ansprüche 1 bis 3, **dadurch gekennzeichnet, dass** der aktive und der passive Teil auf einer selben integrierten Schaltung (CHP) gebaut sind, in ein Gehäuse eingebracht (BO), das eine erste und eine zweite Steckverbindung aufweist, die die ersten und zweiten Versorgungsklemmen (VCC, GND) und die Steckverbindungen bilden, die mit den Eingangs- und Ausgangsklemmen der integrierten Schaltung verbunden sind, wobei die Induktanzen (Lext, Lext) aus den elektrischen Kabeln gebildet werden, die die Ausgangsklemmen (S1, S2) des passiven Teils mit der ersten Steckverbindung des Gehäuses verbinden.

5. Funktelefonapparat, das zum Senden und Empfangen von Funksignalen in einem bestimmten Frequenzbereich konzipiert ist, wobei das Gerät ein Antennen- und Filtersystem (AF) aufweist, das den Empfang eines Signals ermöglicht, dessen Frequenz (RF) innerhalb des besagten Frequenzbereichs ausgewählt wird, in dem Gerät ausgehend von der auszuwählenden Frequenz eine Frequenzumformung auf eine Zwischenfrequenz (IF) mit einem Mischer (MX) vorgenommen wird, der einerseits das ausgewählte Funksignal, und andererseits ein Signal (LO) erhält, das vom Ausgang des lokalen Oszillators (OSC) kommt, wie weiter oben beschrieben, wobei die Frequenz des Signals von einem Steuermodul (CM) gemessen wird, das eine sogenannte Regelspannung (Vtun) an den Ausgang (LO) liefert, die das Regeln der Frequenz des Ausgangssignals des lokalen Oszillators ermöglicht, damit diese gleich der Differenz zwischen der auszuwählenden Frequenz (RF) und der Zwischenfrequenz (IF) ist Funktelefonapparat **dadurch gekennzeichnet, dass** der lokale Oszillator (OSC) jedem beliebigen der Ansprüche 1 bis 4 entspricht.
